# EUROPEAN PATENT APPLICATION

(11) **EP 1 614 654 A2**
(43) Date of publication of application: **11.01.2006**
(21) Application number: 05012367.8
(22) Date of filing: 08.06.2005
(51) Int. Cl.: B81C 1/00, H05B 3/10

(54) **Electronic device having a plurality of conductive beams**

(30) Priority: 06.07.2004 US 885304
(71) Applicant: Hewlett-Packard Development Company, L.P., Houston, TX 77070 (US)
(72) Inventor: Champion, David, Lebanon OR 97355 (US); McConica, Carol, Corvallis OR 97330 (US); McKinnell, James C., NW Salem OR 97304 (US)
(74) Representative: Schoppe, Fritz

(57) **Abstract**

An electronic device (100, 200, 400, 500, 600), including first (121, 221, 321, 421, 521, 621) and second (122, 222, 322, 522, 622) conductive pads, and a first plurality of electrically conductive beams (131, 231, 331, 431, 531, 654) substantially parallel to each other. Each beam has a mesial region (132, 232, 332, 432, 532, 632) having a beam resistance, and first (134, 234, 234', 334, 434, 534, 634) and second (136, 236, 236', 336, 536, 636) end regions extending from the mesial region to the respective first and second conductive pads. Each end region includes an end resistance less than the beam resistance.

## Description

### BACKGROUND

### Description of the Art

The demand for cheaper and higher performance electronic devices has led to a growing need to manufacture electronic devices having lower power consumption as well as improved efficiency. Photonic crystals, micro-vacuum devices, and, in general, in the emerging area of Micro Electro Mechanical Systems (MEMS), which are being developed as smaller alternative systems, to conventional electromechanical devices such as relays, actuators, sensors, valves, and other transducers are all good examples of the ever-increasing demands on power consumption and the need to better handle thermal transfer. The integration of electromechanical devices incorporated in a MEMS device with integrated circuits provides improved performance over conventional systems; however it also requires improved thermal isolation.

Although incandescent lamps are inexpensive and the most widely utilized lighting technology in use today, they are also the most inefficient lighting source in regards to the amount of light generated per unit of energy consumed. An incandescent lamp works by heating a filament, typically tungsten, to a very high temperature so that it radiates in the visible portion of the electromagnetic spectrum. Unfortunately, at such high temperatures the filament radiates a considerable amount of energy in the non-visible infrared region of the electromagnetic spectrum. Photonic crystals, typically, are spatially periodic structures having useful electromagnetic wave properties, such as photonic band gaps. Photonic crystals, having the proper lattice spacing, offer the potential of improving the luminous efficacy of an incandescent lamp by modifying the emissivity of the tungsten filament. Such a filament, incorporated into a photonic crystal, would emit most if not all light in the visible portion of the spectrum and little or no light in the non-visible infrared portion. However, such a filament still must be heated to a temperature in excess of 1500 °K.

Micro-vacuum devices used as amplifying and switching devices are more radiation resistant than semiconductor devices. Such devices also typically utilize a filament heated to a sufficiently high temperature to emit electrons. There is a need for mitigation of the thermal problems such as heat loss and overheating of nearby devices in such micro-fabricated devices. In addition, micro fuel cells, chemical reactors, and sensors all face similar problems.

If these problems persist, the continued growth and advancements in the use of electronic devices, especially in the area of photonic crystals and MEMS devices, in various electronic products, will be reduced. In areas like consumer electronics, the demand for cheaper, smaller, more reliable, and higher performance electronics constantly puts pressure on improving and optimizing performance of ever more complex and integrated devices. The ability to optimize thermal performance will open up a wide variety of applications that are currently either impractical, or are not cost effective.

### BRIEF DESCRIPTION OF THE DRAWINGS

Fig. 1 is an isometric of a plurality of conductive beams according to an embodiment of the present invention.

Fig. 2a is a plan view of a plurality of conductive beams according to an alternate embodiment of the present invention.

Fig. 2b is a plan view of a portion of a conductive beam according to an alternate embodiment of the present invention.

Fig. 2c is a plan view of a portion of a conductive beam according to an alternate embodiment of the present invention.

Fig. 3 is a cross-sectional view of a conductive beam according to an alternate embodiment of the present invention.

Fig.4 is an isometric view of a photonic band gap crystal according to an embodiment of the present invention.

Fig. 5a is a plan view of a photonic band gap crystal according to an alternate embodiment of the present invention.

Fig. 5b is a cross-sectional view along 5b - 5b illustrating the photonic band gap crystal shown in Fig. 5a.

Fig. 6a is a plan view of a vacuum device having multiple thermionic electron emitters according to an embodiment of the present invention.

Fig. 6b is a cross-sectional view along 6b - 6b showing the relationship between the cathode beams disposed directly under the anodes shown in Fig. 6a.

Fig. 6c is a cross-sectional view along 6c - 6c showing a cathode beam and an anode shown in Fig. 6a.

Fig. 6d is a cross-sectional view along 6d - 6d showing a shield disposed between two cathode beams shown in Fig. 6a.

### DESCRIPTION OF THE PREFERRED EMBODIMENTS

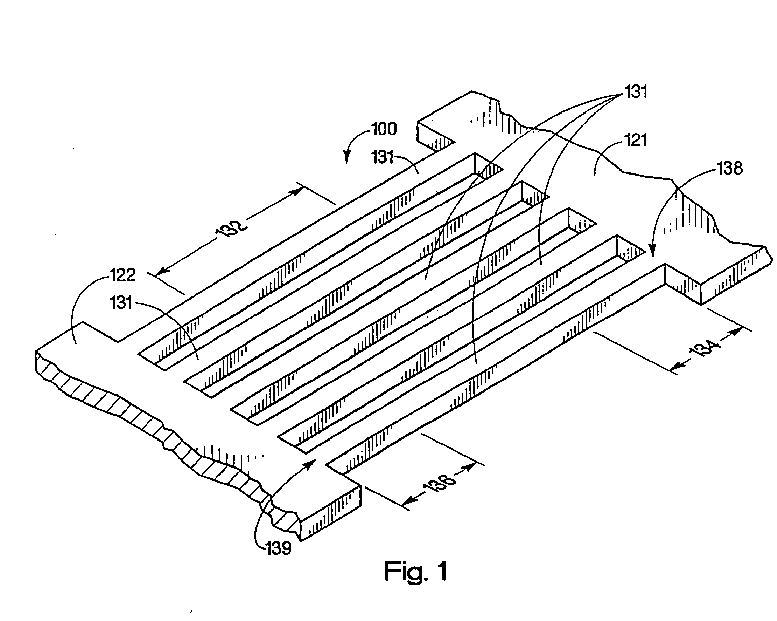

An embodiment of electronic device 100 of the present invention is shown, in an isometric view, in Fig. 1. In this embodiment, electronic device 100 includes multiple conductive beams electrically connected to first conductive pad 121 and second conductive pad 122. Each conductive beam 131 includes central or mesial region 132, which has a beam resistance. In alternate embodiments, the beam resistance is substantially uniform over the length of the mesial region. In addition, each conductive beam 131 also includes a first end region 134 that extends from mesial region 132 to first connection point 138 of first conductive pad 121, and a second end region 136 that extends from mesial region 132 to second connection point 139 of second conductive pad 122. Although in Fig. 1, mesial region 132 is illustrated as having a length greater than either first or second end regions 134 and 136, it should be understood that this is for illustrative purposes only. Mesial region 132 may have a length that is shorter, longer, or equal to the length of the end regions. For example, the mesial region may have a very short length compared to the length of the end regions. In this embodiment, first end region 134 and second end region 136 each has a resistance that increases from first and second connection points 138 and 139 respectively to mesial region 132. In this embodiment, conductive beam 131 may be formed utilizing any metal, alloy, semiconductor, cermet, conductive ceramic, or combinations thereof. In one embodiment, conductive beam 131 is formed from a refractory material such as tungsten, titanium nitride, tantalum, rhenium, molybdenum, iridium, niobium, and rhodium. In addition, first and second conductive pads 121 and 122 are generally formed from the same material utilized to form conductive beam 131; however, in alternate embodiments, the conductive pads may be formed utilizing a material that is different from that used to form conductive beam 131. In this embodiment, various techniques may be utilized to generate the increase in resistance between the connection points and the mesial region. For example, the resistance may be varied by forming a gradient in the composition of the beam utilizing techniques such as varying the concentration of an alloying element or varying the concentration in a compounding element. Examples of materials that may be utilized include; tungsten alloyed with niobium, molybdenum, thorium, or tantalum; molybdenum alloyed with titanium and zirconium; iron alloys, chromium alloys, aluminum alloys; nickel alloys, tantalum alloys, rhenium alloys, silicon alloys; platinum alloyed with ruthenium, titanium nitride with a varying nitrogen concentration, molybdenum silicide with a varying silicon concentration, silicon carbide with a varying silicon to carbon ratio, zirconium carbide, rhodium, tantalum nitride, tantalum carbide, hafnium carbide, hafnium nitride, and ruthernium. In addition, first and second end regions also may be formed from a material that is different from mesial region 132. For example mesial region 132 may be formed from tungsten or a tungsten alloy and first and second end regions 134 and 136 may be formed from titanium nitride with a varying nitrogen concentration. In another example a uniform composition may be utilized and the change in resistance may be formed by a change in thickness or a change in width or some combination thereof.

In one embodiment, the multiple conductive beams may form a portion of a photonic band gap crystal where the crystal materials and structure may be chosen to selectively emit electromagnetic radiation in a particular portion of the electromagnetic spectrum. The particular band gap location desired will depend on various factors such as the dielectric constant of the materials utilized to form the photonic crystal, the lattice constant of the crystal, the particular crystal structure utilized, as well as the particular fill fraction utilized. The width of the band gap will also depend on the uniformity and quality of the crystal structure as well as the number of layers utilized to form the crystal. In a second embodiment, the multiple conductive beams may form an array of electron emitters in, for example, an array of vacuum micro-diodes or triodes. In still other embodiments, the multiple conductive beams of the present invention may form an array of heaters in a MEMs device, micro-chemical reactor, fuel cell, or sensor.

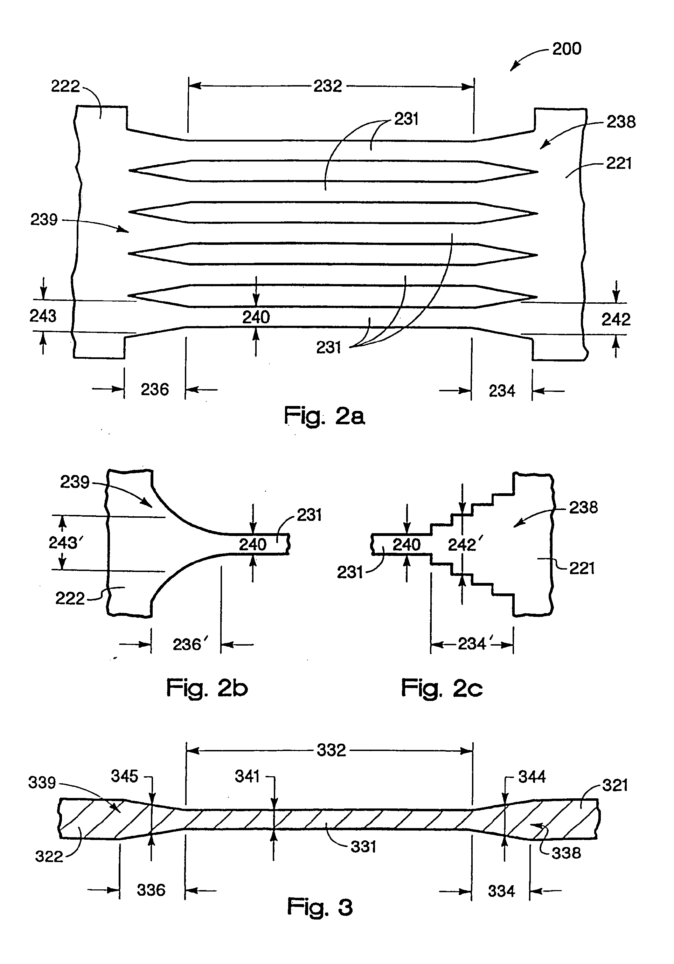

An alternate embodiment of a plurality of conductive beams, of the present invention, is shown, in a plan view, in Fig. 2a. In this embodiment, each conductive beam includes first end region 234 and second end region 236 each having a beam width that increases, providing for a decrease in resistance in the direction from the central portion of the beam toward the conductive pad that electrically couples the multiple beams together. In this embodiment, conductive beam 231, of electronic device 200, has a uniform thickness (not shown) that is the same thickness as first and second conductive pads 221 and 222. Conductive beam 231 includes mesial region 232, which has uniform mesial beam width 240. The uniform thickness and width provide a uniform resistance over the length of conductive beam 231 in the mesial region. Conductive beam 231 is connected to first conductive pad 221 at connection point 238 via first end region 234, and is connected to second conductive pad 222 at connection point 239 via second end region 236. In this embodiment, first end region 234 includes first end region beam width 242 that increases as one moves from mesial region 232 to connection point 238 of first conductive pad 221. Second end region 236 includes second end region beam width 243 that also increases as one moves from mesial region 232 to connection point 239 of second conductive pad 222. In this embodiment, as illustrated in Fig. 2a end region beam widths 242 and 243 linearly increase from mesial region 232 to the respective connection point, however, as illustrated in Figs. 2b and 2c other variations also may be utilized. For example, as illustrated in Fig. 2b second end region 236' includes second end region beam width 243' that non-linearly increases as one moves from the mesial region to connection point 239 of second conductive pad 222. Another example is illustrated in Fig. 2c where first end region beam width 242' varies in a step-wise manner in the direction going from the mesial region to connection point 238 of first conductive pad 221.

An alternate embodiment of a conductive beam, of the present invention, is shown, in a cross-sectional view, in Fig 3. In this embodiment, conductive beam 331 has end regions whose thickness increases. Conductive beam 331 includes mesial region 332 having uniform mesial beam width 341 over the length of the beam in the mesial region. Conductive beam 331 is connected to first conductive pad 321 at connection point 338 via first end region 334, and is connected to second conductive pad 322 at connection point 339 via second end region 336. In this embodiment, first end region 334 includes first end region beam thickness 344 that increases in the direction from mesial region 332 to connection point 338 of first conductive pad 321. Second end region 336 includes second end region beam thickness 345 that also increases in the direction from mesial region 332 to connection point 339 of second conductive pad 322. In this embodiment, as illustrated in Fig. 3 end region beam thicknesses 344 and 345 smoothly increase from mesial region 332 to the respective connection point. Such a smoothly varying thickness may be formed, for example, by utilizing a slope metal etch after the beam is formed. In addition, the smoothly varying thickness also may be formed via a shadow mask during formation of the beam. In still other embodiments, a stepwise variation in thickness also may be utilized.

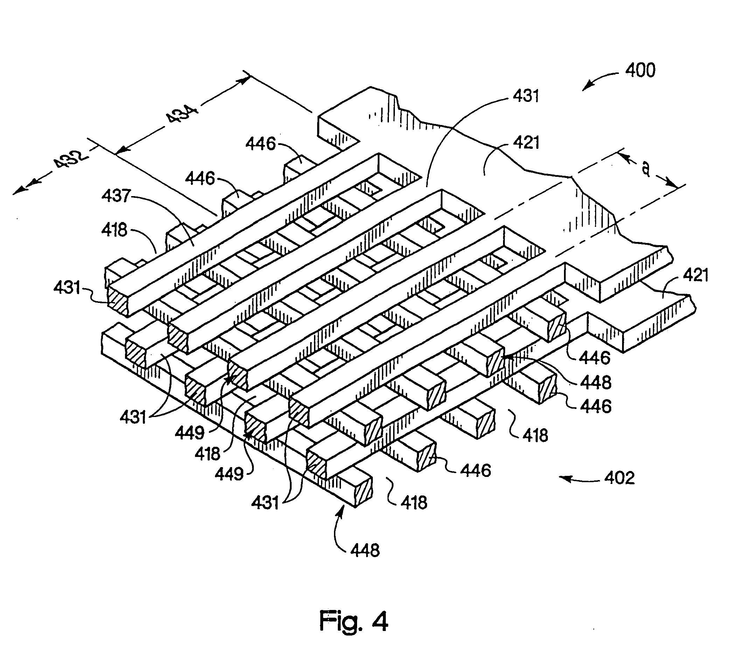

An alternate embodiment of electronic device 400 is shown, in an isometric view, in Fig. 4. In this embodiment, electronic device 400 includes photonic band gap crystal 402 having a lattice spacing a and a face-centered-tetragonal lattice symmetry. Fig. 4 illustrates only a portion of complete photonic band gap crystal. In this embodiment, photonic band gap crystal 402 has a lattice spacing of 0.7 micrometers and selectively emits in the visible and near-infrared wavelengths and provides for a more efficient incandescent emitter or light source compared to typical tungsten or refractory metal filaments. The particular region of the electromagnetic spectrum in which the photonic band gap crystal will emit depends on various factors such as the lattice spacing utilized, the dielectric constant of the materials utilized to form the crystal structure, and the crystal structure. Photonic band gap crystal 402 includes alternating layers 448 and 449. Each layer 449 includes conductive beams 431 evenly spaced apart a distance a and substantially parallel to each other. In addition, each layer 449 is shifted relative to the other layer by 0.5a. Each conductive beam includes central region 432 having a substantially uniform resistance over the length of the mesial region. In alternate embodiments, the spacing between conductive beams 431 may be varied forming a disordered layer. In addition in still other embodiments, the shifting between each layer also may be varied forming a disordered crystal structure. Each conductive beam also includes first end region 434 that extends from central region 432 to conductive pad 421, and has a resistance that increases in the direction from the conductive pad to the central region. In this embodiment, first end region 434 extends at least one lattice spacing into the photonic band gap crystal structure.

Each layer 448 includes crystal or lattice beams 446 that are also evenly spaced apart a distance a, substantially parallel to each other, and mutually orthogonal to conductive beams 431. Thus, photonic band gap crystal 402 has a stacking sequence that repeats itself every four layers with a repeat distance t. In this embodiment, conductive beams 431 and crystal beams 446 are formed from the same material and have a first dielectric constant; however, in alternate embodiments, lattice beams 446 also may be formed utilizing a material that is different from that used to form conductive beams 431. Each layer 448 is also shifted relative to the other layer by 0.5a. As noted above for layers 449 the spacing between beams and between layers also may be varied forming disordered layers and a disordered crystal structure. Examples of materials that may be utilized to form lattice beams 446 include tungsten, titanium nitride, tungsten alloys, rhenium, carbon, titania, silicon carbide, and iridium. The volume between the beams, i.e. interstitial volume 418, is filled by a material having a second dielectric constant. In this embodiment, interstitial volume 418 is a vacuum; however, in alternate embodiments other materials also may be utilized such as air or a ceramic material. The particular material utilized to form the interstitial volume will depend on various factors such as the desired energy band gap edge, the desired operating temperature and pressure as well as the environment in which the device will be utilized. In this embodiment, electronic device 400 also includes a cover and a device base or enclosure (not shown) that encloses photonic band gap crystal 402 forming a hermetic seal whereby the enclosure may be maintained at a pressure below atmosphere.

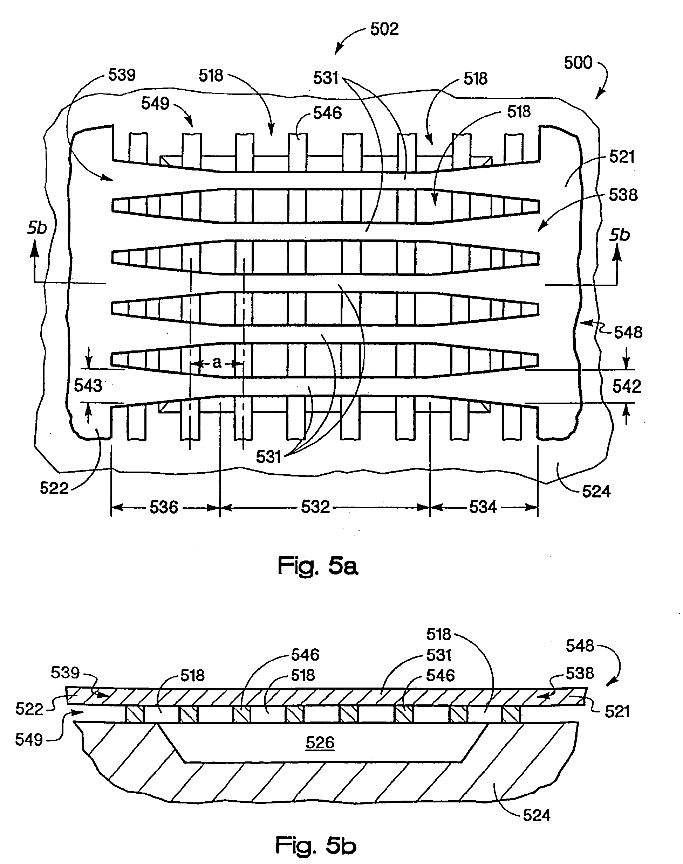

An alternate embodiment of a photonic band gap crystal is shown, in a plan view, in Fig. 5a. In this embodiment, photonic band gap crystal 502, disposed within photonic device 500, includes layer 548 and layer 549 disposed over cavity or recessed structure 526 as illustrated in a cross-sectional view in Fig. 5b. For illustrative purposes only Figs. 5a and 5b depict only two layers of photonic band gap crystal 502; however, it should be understood that the photonic crystal includes at least four layers as previously described, and, generally, it will include more than four layers. Layer 549 includes crystal beams 546 that are evenly spaced apart a distance a and are substantially parallel to each other with the majority of beams disposed over cavity 526 formed in substrate 524. Interstitial volume 518, in this embodiment, is a vacuum; however, in alternate embodiments other materials having a second dielectric constant different from that of the beams also may be utilized. In this embodiment, crystal beams 546 have a beam width of 425 nanometers and a spacing of 575 nanometers between the crystal beams; however, in alternate embodiments, other beam widths and beam spacings also may be utilized. The particular beam width and beam spacing utilized will depend on various factors such as the dielectric constant of the materials forming the crystal, and the temperature to which the crystal is heated.

Layer 548 includes conductive beams 531 that are evenly spaced apart a distance a, are substantially parallel to each other, and mutually orthogonal to crystal beams 546. Each conductive beam includes central portion 532 having a substantially uniform resistance over the length of the central region. In addition, each conductive beam includes first and second end regions 534 and 536 that extend from central portion 532 to conductive pads 521 and 522 respectively. Each end region has a beam width 542 and 543 that increases in the direction from the central portion of the beam toward connection points 538 and 539 of their respective conductive pad, thereby providing for a decrease in resistance over this length. First and second end regions 534 and 536 extend at least one lattice spacing into the photonic band gap crystal structure. In addition, conductive beams 531 and crystal beams 546 have a uniform thickness, as is illustrated in Fig. 5b; however, in alternate embodiments, first and second end regions 534 and 536 may also have a non-uniform thickness. In this embodiment, substrate 524 is a silicon substrate and cavity 526 is depicted as having sloping sidewalls; however, in alternate embodiments straight vertical sidewalls or other more complex structures also may be utilized. An anisotropic wet etch such as KOH or tetra methyl ammonium hydroxide (TMAH), may be utilized to etch a (100) oriented silicon wafer to produce various structures with sloped side walls generated by the slower etch rate of the (111) crystallographic planes. In alternate embodiments, combinations of wet and dry etch may also be utilized when more complex structures are desired. In still other embodiments, substrate 524 may be formed from a wide variety of materials including metals, ceramics and other semiconductors. In addition, a reflective layer (not shown) may be formed in cavity 526 to reflect light transmitted toward substrate 524. The reflective layer may coat or line all of cavity 526 or it may be disposed only in portions of cavity 526.

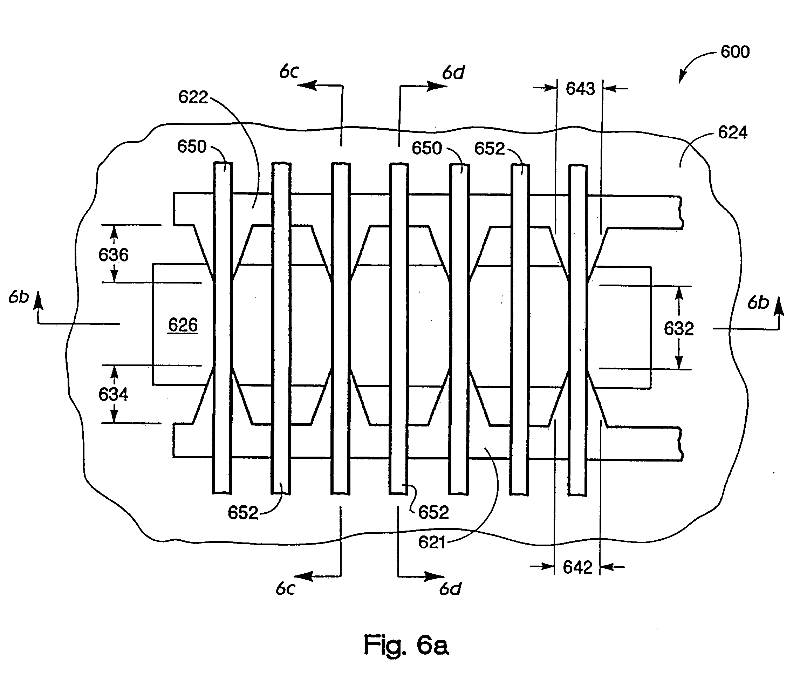

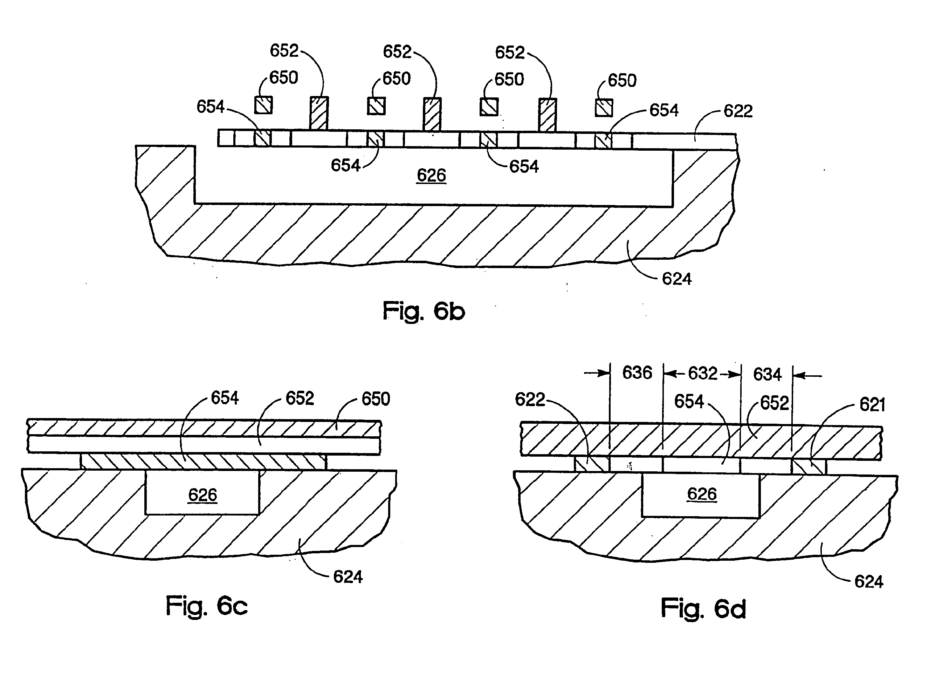

An alternate embodiment of the present invention is shown, in plan view, in Fig. 6a. In this embodiment, vacuum device 600 includes an array of thermionic emitters. As illustrated in cross-sectional view in Figs. 6b-6d cavity 626 is formed in substrate 624. Disposed over cavity 626 are multiple cathode beams 654 as shown in Figs. 6b-6d. Each cathode beam includes filament region 632 having a substantially uniform resistance over the length of the filament region. In addition, each cathode beam includes first and second connecting portions 634 and 636 that extend from filament region 632 to conductive pads 621 and 622 respectively. Each connecting portion has a beam width 642 and 643 that increases in the direction from the central portion of the beam toward the respective conductive pad, thereby providing for a decrease in resistance. Vacuum device 600 also includes anode 650 disposed over cathode beams 654. Disposed between each set of an anode and a cathode is shield structure 652 which may be biased to hinder cross talk between neighboring sets of anodes and cathodes. In addition, in this embodiment vacuum device 600 also includes a cover (not shown) disposed over the plurality of electrically conductive beams. The cover is attached either to substrate 624 or to a device base (not shown) on which substrate 424 is mounted to form a hermetic seal so that the vacuum device may operate at a pressure below atmospheric pressure.

In this embodiment, a voltage source (not shown) is connected between cathode beams 654 and anodes 650 where cathode beams 654 arc negatively biased relative to anodes 650. In addition, a current source (not shown) is applied across cathode beams 654 causing them to heat up to a sufficiently high temperature to thermionically emit electrons to anode 650. When the polarity of the voltage source is reversed electrons current will no longer flow between the cathode and anode. Such a structure is a thermionic emission diode or vacuum diode, which can be utilized, for example, as a rectifier or as a sensor of external electric or magnetic fields. In addition, in alternate embodiments, anode 650 may be coated with a cathodoluminescent material, which will emit a well-defined spectrum of electromagnetic radiation when impacted by electrons emitted from cathode beam 654. In still other embodiments grid electrodes may be disposed between cathode beam 654 and anode 650 to form triodes, tetrodes etc. In such devices the grid electrode is normally biased negative relative to cathode beam 654 so that as the grid voltage is reduced, the electric field at the cathode is decreased with a corresponding decrease in current flowing to anode 650. Relatively small changes in the grid voltage cause relatively large changes in the anode current, thus the grid can be utilized as the input in an amplifying circuit.

Substrate 624, in this embodiment, is silicon substrate; however, in alternate embodiments, a wide variety of substrate materials may be utilized including metal or semiconductive substrates having an insulating layer disposed between the cathode beams and the substrate surface. In addition, glass and ceramic substrates also may be utilized. In addition, a cover or vacuum enclosure is also utilized to provide for the low pressure environment in which the cathode beams are heated to emit electrons. Cathode beams 654, anodes 650 and shields 652 are formed from tungsten; however, in alternate embodiments, other refractory materials such as tantalum, rhenium, platinum, iridium, zirconium, or molybdenum also may be utilized. In still other embodiments, various electron emitter materials such as lanthanumhexaboride, thorium oxide, or barium and strontium oxides may either be coated on or dispersed within cathode beams 650. In one embodiment, anodes 650 are each coated with a cathodoluminescent material so that electrons emitted from filament regions 632 impact the cathodoluminescent material on the anodes thereby emitting radiation. In this embodiment, the cover may be transparent to the wavelengths emitted or the cover may include transparent portions.

## Claims

1. An electronic device (100, 200, 400, 500, 600), comprising:
a first conductive pad (121, 221, 321, 421, 521, 621);
a second conductive pad (122, 222, 322, 522, 622);
a first plurality of electrically conductive beams (131, 231, 331, 431, 531, 654) substantially parallel to each other, each beam of said first plurality of electrically conductive beams having,
a mesial region (132, 232, 332, 432, 532, 632) having a beam resistance,
a first end region (134, 234, 234', 334, 434; 534, 634) extending from said mesial region to said first conductive pad, and
a second end region (136, 236, 236', 336, 536, 636) extending from said mesial region to said second conductive pad, wherein said first and said second end regions each include an end resistance less than said beam resistance.

2. The electronic device in accordance with claim 1, wherein said end resistance decreases from said mesial region to said respective conductive pad.

3. The electronic device in accordance with claim 1, wherein said first end region further comprises a beam width (242, 243, 242', 243', 542, 543, 642, 643), said beam width increases from said mesial region to said first conductive pad.

4. The electronic device in accordance with claim 1, wherein said first end region further comprises a beam thickness (344, 345), said beam thickness increases from said mesial region to said first conductive pad.

5. The electronic device in accordance with claim 1, wherein said first end region further comprises a varying composition gradient.

6. The electronic device in accordance with claim 5, wherein said varying composition gradient further comprises at least one alloying element, whereby the concentration of said at least one alloying element decreases from said mesial region to said first conductive pad.

7. The electronic device in accordance with claim 1, further comprising a substrate having a recessed structure (526, 626) disposed therein and said mesial region of each of said first plurality of electrically conductive beams disposed over said recess structure.

8. The electronic device in accordance with claim 1, wherein said mesial region of each of said first plurality of electrically conductive beams further comprises a filament portion (632) adapted to emit electrons.

9. The electronic device in accordance with claim 8, further comprising a plurality of anodes (650) each having a cathodoluminescent material disposed thereon, and wherein said cover further comprises a transparent cover portion, wherein electrons emitted from each of said filament portions of said first plurality of electrically conductive beams impact one of said plurality of anodes emitting radiation from said cathodoluminescent material.

10. The electronic device in accordance with claim 8, further comprising a plurality of anodes (650), wherein said filament portions of said first plurality of electrically conductive beams and said plurality of anodes forming a plurality of diode structures.

11. The electronic device in accordance with claim 1, further comprising a first plurality of lattice beams (446, 546) substantially parallel to each other and substantially mutually orthogonal to said first plurality of electrically conductive beams.

12. The electronic device in accordance with claim 11, wherein said plurality of electrically conductive beams is formed from a material having a first dielectric constant, and wherein said first plurality of lattice beams is formed utilizing a material having a lattice beam dielectric constant different from said first dielectric constant.

13. The electronic device in accordance with claim 11, further comprising an interstitial volume (418, 518) formed between said plurality of electrically conductive beams and said plurality of lattice beams, said interstitial volume having an interstitial dielectric constant different from the dielectric constants of said lattice beams and said electrically conductive beams.

14. The electronic device in accordance with claim 11, wherein said first plurality of electrically conductive beams further comprises a beam pitch D, wherein said first plurality of lattice beams further comprises said beam pitch D.

15. The electronic device in accordance with claim 14, further comprising:
a second plurality of electrically conductive beams substantially parallel to each other and substantially parallel to said first plurality of conductive beams, said second plurality of conductive beams having said beam pitch of D wherein said second plurality of electrically conductive beams is shifted relative to said first plurality of conductive beams, said first plurality of lattice beams disposed between said first and said second plurality of electrically conductive beams; and
a second plurality of lattice beams substantially parallel to each other and substantially parallel to said first plurality of lattice beams, said second plurality of lattice beams having said beam pitch of D, wherein said second plurality of lattice beams is shifted relative to said first plurality of lattice beams, said second plurality of electrically conductive beams disposed between said first and said second plurality of lattice beams.

16. An electronic device (100, 200, 400, 500, 600), comprising:
means for forming at least two conductive pads(121, 221, 321, 421, 521, 621, 122, 222, 322, 522, 622);
a plurality of conductive beams (131, 231, 331, 431, 531, 654) substantially parallel to each other, each beam having:
means for connecting an end resistance portion to each of said at least two conductive pads, and
means for connecting said increasing beam end resistance portion to a central beam region (132, 232, 332, 432, 532, 632) having a central beam resistance, wherein said end resistance portion includes an end resistance greater than said central beam resistance.
